(19) **Europäisches Patentamt**
**European Patent Office**
**Office européen des brevets**

(11) **EP 2 039 447 B1**

(12) **EUROPEAN PATENT SPECIFICATION**

(45) Date of publication and mention
of the grant of the patent:
**06.07.2011 Bulletin 2011/27**

(51) Int Cl.:
**B22F 7/00** (2006.01)     **C23C 30/00** (2006.01)
**C22C 29/08** (2006.01)

(21) Application number: **08164069.0**

(22) Date of filing: **10.09.2008**

(54) **Coated cutting insert for milling applications**

Beschichteter Schneideeinsatz für Fräsanwendungen

Insert de découpage revêtu pour applications de fraisage

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **13.09.2007 SE 0702045**

(43) Date of publication of application:
**25.03.2009 Bulletin 2009/13**

(73) Proprietor: **Seco Tools AB**
**737 82 Fagersta (SE)**

(72) Inventors:
• **Sandberg, Anna**
**SE-733 93, Sala (SE)**

• **Larsson, Andreas**
**SE-737 33, Fagersta (SE)**
• **Larsson, Tommy**
**SE-737 90, Ängelsberg (SE)**

(74) Representative: **Hägglöf, Henrik**
**Sandvik Intellectual Property AB**
**811 81 Sandviken (SE)**

(56) References cited:
**EP-A- 0 753 603     EP-A- 1 493 845**
**WO-A-97/20083**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The present invention relates to a coated cemented carbide insert (cutting tool) particularly useful for wet or dry milling of steels.

When machining low and medium alloyed steels and stainless steels with cemented carbide tools, the cutting edge is worn according to different wear mechanisms, such as chemical wear, abrasive wear, adhesive wear and by edge chipping caused by cracks formed along the cutting edge. The domination of any of the wear mechanisms is determined by the application, and is dependent on properties of the machined material, applied cutting parameters and the properties of the tool material. In general, it is very difficult to improve all tool properties simultaneously, and commercial cemented carbide grades have usually been optimised with respect to one or few of the above mentioned wear types, and have consequently been optimised for specific application areas.

EP 1493845 relates to a coated cemented carbide insert (cutting tool), particularly useful for milling of stainless steels and super alloys but also milling of steels in toughness demanding applications. The cutting tool insert is characterised by a cemented carbide body comprising WC, NbC and TaC, a W-alloyed Co binder phase, and a coating comprising an innermost layer of $TiC_xN_yO_z$ with equiaxed grains, a layer of $TiC_xN_yO_z$ with columnar grains and a layer of $\alpha$-$Al_2O_3$.

WO 97/20083 discloses a coated cutting insert particularly useful for milling of low and medium alloyed steels and stainless steels with raw surfaces such as cast skin, forged skin, hot or cold rolled skin or pre-machined surfaces under unstable conditions. The insert is characterised by a WC-Co cemented carbide with a low content of cubic carbides and a rather low W-alloyed binder phase and a coating including an innermost layer of $TiC_xN_yO_z$ with columnar grains and a top layer of TiN and an inner layer of $\kappa$-$Al_2O_3$.

WO 97/20081 describes a coated milling insert particularly useful for milling in low and medium alloyed steels with or without raw surface zones during wet or dry conditions. The insert is characterised by a WC-Co cemented carbide with a low content of cubic carbides and a highly W-alloyed binder phase and a coating including an inner layer of $TiC_xN_yO_z$ with columnar grains, an inner layer of $\kappa$-$Al_2O_3$ and, preferably, a top layer of TiN.

EP 1103635 discloses a cutting tool insert particularly useful for wet and dry milling of low and medium alloyed steels and stainless steels as well as for turning of stainless steels. The invented cutting tool is comprised of a cemented carbide body with a coating consisting of an MTCVD Ti(C,N) layer and a multi-layer coating being composed of $\kappa$-$Al_2O_3$ and TiN or Ti(C,N) layers.

WO 2007/069973 discloses a coated cutting tool insert particularly useful for dry and wet machining, preferably milling, in low and medium alloyed steels, stainless steels, with or without raw surface zones. The insert is characterized by a WC-TaC-NbC-Co cemented carbide with a W alloyed Co-binder phase and a coating including an innermost layer of $TiC_xN_yO_z$ with columnar grains and a top layer at least on the rake face of a smooth $\alpha$-$Al_2O_3$.

It is an object of the present invention to provide a coated cutting tool with enhanced performance for milling of steels.

The cutting tool insert according to the present invention includes a cemented carbide substrate with a relatively low amount of cubic carbides, with a relatively high binder phase content, that is medium to highly alloyed with W and a fine to medium WC grain size. This substrate is provided with a wear resistant coating comprising an equiaxed $TiC_xN_yO_z$ layer, a columnar $TiC_xN_yO_z$ layer, and at least one $\alpha$-$Al_2O_3$ layer.

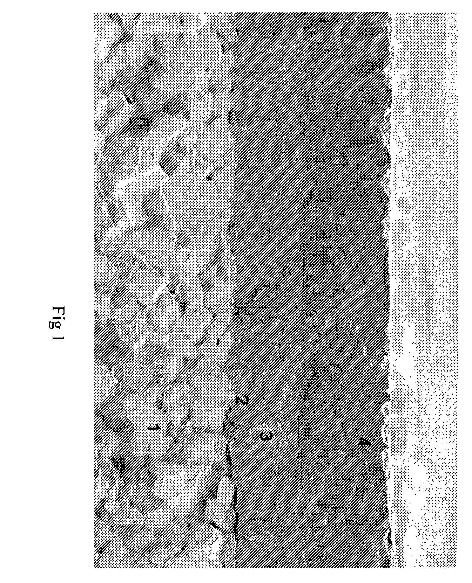

Fig 1 shows in 16000x a scanning electron microscopy image of a fracture cross section of a cemented carbide insert according to the present invention in which

    1. Cemented carbide body,
    2. Innermost $TiC_xN_yO_z$ layer,
    3. $TiC_xN_yO_z$ layer with columnar grains and
    4. $\alpha$-$Al_2O_3$ layer.

According to the present invention a coated cutting tool insert is provided with a cemented carbide body having a composition of 9.75-10.7 wt-% Co, most preferably 9.9-10.5 wt-% Co; 0.5-2.5 wt-%, preferably 1.0-2.0 wt-%, most preferably 1.2-1.8 wt-% total amount of the metals Ti, Nb and Ta and balance WC. Ti, Ta and/or Nb may also be replaced by other elements from groups IVb, Vb or VIb of the periodic table. The content of Ti is preferably on a level corresponding to a technical impurity.

In a preferred embodiment, the ratio between the weight concentrations of Ta and Nb is within 7.0-12.0, preferably 7.6-11.4, most preferably 8.2-10.5.

In an alternative preferred embodiment, the ratio between the weight concentrations of Ta and Nb is within 1.0-5.0, preferably 1.5-4.5.

The cobalt binder phase is medium to highly alloyed with tungsten. The content of W in the binder phase may be expressed as the S-value=$\sigma/16.1$, where $\sigma$ is the magnetic moment of the binder phase in $\mu Tm^3kg^{-1}$. The S-value

depends on the content of tungsten in the binder phase and increases with a decreasing tungsten content. Thus, for pure cobalt, or a binder in a cemented carbide that is saturated with carbon, S=1, and for a binder phase that contains W in an amount that corresponds to the borderline to formation of η-phase, S=0.78.

The cemented carbide body has an S-value within the range 0.81-0.95, preferably 0.82-0.93, most preferably 0.85-0.90.

The cemented carbide has a coercivity (Hc) of 10-15, preferably 11-14, most preferably 11.5-13.5 kA/m.

The coating comprises:

- a first (innermost) layer of $TiC_xN_yO_z$ with $0.7 \leq x+y+z \leq 1$, preferably z<0.5, more preferably y>x and z<0.2, most preferably y>0.7, with equiaxed grains and a total thickness <1 μm, preferably >0.1 μm.
- a layer of $TiC_xN_yO_z$ with $0.7 \leq x+y+z \leq 1$, preferably with z<0.2, x>0.3 and y>0.2, most preferably x>0.4, with a thickness of 1-5 μm, preferably 1.5-4.5 μm, most preferably 2-4 μm, with columnar grains.
- a layer of $Al_2O_3$ consisting of the α-phase. The $Al_2O_3$ layer has a thickness of 1-5 μm, preferably 1.5-4.5 μm, and most preferably 2-4 μm.

The $Al_2O_3$ layer is strongly textured in the (1014)-direction, with a texture coefficient TC(1014) larger than 1.2, preferably between 1.4 and 4.

The texture coefficient (TC) for the alumina layer is determined according to the following formula:

$$TC(hkil) = \frac{I(hkil)}{I_0(hkil)} \left[ \frac{1}{n} \sum_{n=1}^{n} \frac{I(hkil)}{I_0(hkil)} \right]^{-1}$$

where

I(hki1) = measured intensity of the (hkil) reflection
$I_0$(hkil) = standard intensity according to JCPDS card no 46-1212
n = number of reflections used in the calculation
(hkil) reflections used are: (1012), (1014), (112 0), (0006), (112 3), (112 6).
Consequently, n = 6 and the maximum value of the texture coefficient is 6.

In an alternative embodiment, the $Al_2O_3$ layer is strongly textured in the (0006)-direction, with a texture coefficient TC(0006) larger than 1.2, preferably between 1.4 and 4.3.

In another alternative embodiment, the $Al_2O_3$ layer is strongly textured in the (1012)-direction, with a texture coefficient TC(1012) larger than 2.5, preferably larger than 3, most preferably larger than 3.5.

In a further alternative embodiment, there is a thin, less than 1 μm thick, TiN top layer on the α-$Al_2O_3$ layer.

The present invention also relates to a method of making a cutting insert by powder metallurgical technique, wet milling of powders forming hard constituents and binder phase, compacting the milled mixture to bodies of desired shape and size and sintering, comprising a cemented carbide substrate and a coating. According to the method a substrate is provided with a composition of 9.75-10.7 wt-% Co, most preferably 9.9-10.5 wt-% Co; 0.5-2.5 wt-%, preferably 1.0-2.0 wt-%, most preferably 1.2-1.8 wt-% total amount of the metals Ti, Nb and Ta and balance WC. Ti, Ta and/or Nb may also be replaced by other elements from groups IVb, Vb or VIb of the periodic table. The content of Ti is preferably on a level corresponding to a technical impurity.

In a preferred embodiment, the ratio between the weight concentrations of Ta and Nb is within 7.0-12.0, preferably 7.6-11.4, most preferably 8.2-10.5.

In an alternative preferred embodiment, the ratio between the weight concentrations of Ta and Nb is within 1.0-5.0, preferably 1.5-4.5.

The coercivity depends on the grain size of the starting powders and milling and sintering conditions and has to be determined by experiments. The desired S-value depends on the starting powders and sintering conditions and also has to be determined by experiments.

The layer of $TiC_xN_yO_z$ with $0.7 \leq x+y+z \leq 1$, preferably with z<0.2, x>0.3 and y>0.2, most preferably x>0.4, having a morphology of columnar grains, is deposited with MTCVD-technique onto the cemented carbide using acetonitrile as the carbon and nitrogen source for forming the layer in the temperature range of 700-950°C.

The innermost $TiC_xN_yO_z$ layer and alumina layers are deposited according to known technique.

In an alternative embodiment, a thin, less than 1 μm, TiN top layer is deposited on the α-$Al_2O_3$ layer using known technique.

In a further preferred embodiment, the cutting tool insert as described above is treated after coating with a wet blasting or brushing operation, such that the surface quality of the coated tool is improved.

The invention also relates to the use of cutting tool inserts according to the above for wet or dry milling of steels at cutting speeds of 75-400 m/min, preferably 100-300 m/min, with an average feed per tooth of 0.08-0.5 mm, preferably 0.1-0.4 mm depending on cutting speed and insert geometry.

Example 1

Grade A: A cemented carbide substrate in accordance with the invention with the composition 10.3 wt% Co, 1.35 wt% Ta, 0.15 wt% Nb and balance WC, with a binder phase alloyed with W corresponding to an S-value of 0.87 was produced by conventional milling of the powders, pressing of green compacts and subsequent sintering at 1430°C. The Hc value of the cemented carbide was 12.5 kA/m, indicating a mean intercept length of about 0.7 $\mu$m The substrate was coated with a 0.2 $\mu$m thick layer of TiN layer, having equiaxed grains, a 2.9 $\mu$m thick layer of columnar $TiC_xN_yO_z$ deposited at 835-850°C with acetonitrile as carbon and nitrogen source, yielding an approximated carbon to nitrogen ratio x/y=1.5 with z<0.1, and a 3.1 $\mu$m thick layer of $\alpha$-$Al_2O_3$ deposited at about 1000°C. X-ray diffraction showed that the $\alpha$-$Al_2O_3$ layer had a TC(1014) of 2.1. Fig 1 shows in 16000x a scanning electron microscopy image of a fracture cross section of the coated cemented carbide. The cutting tool insert was treated after coating with a wet blasting operation.

Grade B: A cemented carbide substrate according to Grade A was combined with a 3 $\mu$m Ti(C,N) and a 3 $\mu$m multi-layer coating of four $\kappa$-$Al_2O_3$ and five TiN layers.

Grade A and B were tested in a face milling operation in steel.

| Operation | Face milling |
|---|---|
| Cutter diameter | 160 mm |
| Material | St 52-3 |
| Insert type | SEEX1204AFTN-M14 |
| Cutting speed | 190 m/min |
| Feed | 0.25 mm/tooth |
| Depth of cut | 3 mm |
| Width of cut | 130 mm |
| | |
| Results | Tool life (min) |
| Grade A (grade according to invention) | 300 |
| Grade B | 160 |

The test was stopped at the same maximum flank wear. The wear resistance was much improved with the grade according to the invention.

Example 2

Grade C: A cemented carbide substrate with the composition 13 wt% Co, 1.35 wt% Ta, 0.15 wt% Nb and balance WC, with a binder phase alloyed with W corresponding to an S-value of 0.85 and a Hc value of 14 kA/m was coated in accordance with Grade A.

Grade D: A cemented carbide substrate in with the composition 12 wt% Co, 1.3 wt% Ta, 0.2 wt% Nb and balance WC, with a binder phase alloyed with W corresponding to an S-value of 0.89 and a Hc value of 13 kA/m was coated in accordance with Grade A.

Grades A, C and D were tested in a square shoulder milling operation in steel.

| Operation | Square shoulder milling |
|---|---|
| Cutter diameter | 63 mm |
| Material | AISI 4142 |

(continued)

| Operation | Square shoulder milling |
|---|---|
| Insert type | XOMX180608TR-MD15 |
| Cutting speed | 200 m/min |
| Feed | 0.18 mm/tooth |
| Depth of cut | 12 mm |
| Width of cut | 36 mm |
| | |
| Results | Tool life (min) |
| Grade A (grade according to invention) | 300 |
| Grade C | 224 |
| Grade D | 168 |

The test was stopped at the same maximum flank wear. The tool life was significantly lower for the grades with higher binder phase content.

**Claims**

1. A cutting tool insert, comprising a cemented carbide body and a coating, particularly useful for wet or dry milling of steels wherein the said body has a composition of 9.75-10.7 wt% Co, 0.5-2.5 wt%, preferably 1.0-2.0 wt%, total amount of the metals Ti, Nb and Ta and balance WC, with a coercivity of 10-15, preferably 11-14 kA/m, the binder phase alloyed with W corresponding to an S-value of 0.81-0.95, preferably 0.82-0.94, and that said coating comprises

   - a first (innermost) layer of $TiC_xN_yO_z$ with $0.7 \leq x+y+z \leq 1$, preferably $z<0.5$, more preferably $y>x$ and $z<0.2$, with equiaxed grains and a total thickness $<1$ $\mu$m, preferably $>0.1$ $\mu$m;
   - a layer of $TiC_xN_yO_z$ with $0.7 \leq x+y+z \leq 1$, preferably with $z<0.2$, $x>0.3$ and $y>0.2$, most preferably $x>0.4$, with a thickness of 1-5 $\mu$m, preferably 1.5-4.5 $\mu$m with columnar grains;
   - a layer of textured $Al_2O_3$ consisting of the $\alpha$-phase with a thickness of 1-5 $\mu$m, preferably 1.5-4.5 $\mu$m whereby the $Al_2O_3$ layer is strongly textured in the $(10\bar{1}4)$-direction, with a texture coefficient $TC(10\bar{1}4)$ larger than 1.2, preferably between 1.4 and 4 or in the (0006)-direction, with a texture coefficient TC(0006) larger than 1.2, preferably between 1.4 and 4.3, or in the $(10\bar{1}2)$-direction, with a texture coefficient TC(1012) larger than 2.5, preferably larger than 3, most preferably larger than 3.5.

   the texture coefficient (TC) being determined according to the following formula:

$$TC(hkil) = \frac{I(hkil)}{I_0(hkil)} \left[ \frac{1}{n} \sum_{n=1}^{n} \frac{I(hkil)}{I_0(hkil)} \right]^{-1}$$

   where
   I(hkil) = measured intensity of the (hkil) reflection
   $I_O$(hkil) = standard intensity according to JCPDS card no 46-1212
   n = number of reflections used in the calculation
   (hkil) reflections used are; $(10\bar{1}2)$, $(10\bar{1}4)$, $(11\bar{2}0)$, (0006), $(11\bar{2}3)$, $(11\bar{2}6)$.

2. A cutting tool insert according to the preceding claim **characterised in characterised in** a Co-content of 9.9-10.5 wt-%.

3. A cutting tool insert according to any of the preceding claims **characterised in** a ratio between the weight concentrations of Ta and Nb of 7.0-12.0, preferably 7.6-11.4.

**4.** A cutting tool insert according to any of claims 1 and 2 **characterised in** a ratio between the weight concentrations of Ta and Nb of 1.0-5.0, preferably 1.5-4.5.

**5.** A cutting tool insert according to any of the preceding claims **characterised in** a Ti-content on the level of technical impurity.

**6.** A cutting tool insert according to any of the preceding claims **characterised in** a thin TiN top layer on the $\alpha$-Al$_2$O$_3$ layer.

**7.** A method of making a cutting tool insert comprising a cemented carbide body and a coating by

- preparing by powder metallurgical technique, a cemented carbide body having a composition of 9.75-10.7 wt% Co, 0.5-2.5 wt%, preferably 1.0-2.0 wt% total amount of the metals Ti, Nb and Ta and balance WC, with a coercivity of 10-15, preferably 11-14 kA/m, the binder phase alloyed with W corresponding to an S-value of 0.81-0.95, preferably 0.82-0.94, and
- coating the cemented carbide body with
- a first (innermost) layer of TiC$_x$N$_y$O$_z$ with $0.7 \leq x+y+z \leq 1$, preferably z<0.5, more preferably y>x and z<0.2, with equiaxed grains and a total thickness <1 $\mu$m, preferably >0.1 $\mu$m using known CVD-technique,
- a layer of TiC$_x$N$_y$O$_z$ with $0.7 \leq x+y+z \leq 1$, preferably with z<0.2, x>0.3 and y>0.2, most preferably x>0.4, with a thickness of 1-5 $\mu$m, preferably 1.5-4.5 $\mu$m with columnar grains using MTCVD-technique with acetonitrile as the carbon and nitrogen source for forming the layer in the temperature range of 700-950°C,
- a layer of textured Al$_2$O$_3$ consisting of the $\alpha$-phase with a thickness of 1-5 $\mu$m, preferably 1.5-4.5 $\mu$m, using known CVD-technique and
- possibly depositing a thin TiN top layer on the $\alpha$-Al$_2$O$_3$ layer using known technique.

**8.** Use of a cutting tool inserts according to claims 1-6 for milling of steels at cutting speeds of 75-400 m/min, preferably 100-300 m/min, with an average feed per tooth of 0.08-0.5 mm, preferably 0.1-0.4 mm depending on cutting speed and insert geometry.

**Patentansprüche**

**1.** Schneidwerkzeugeinsatz, welcher einen Korpus aus Sintercarbid und eine Beschichtung aufweist, insbesondere verwendbar für Nass- oder Trockenfräsen von Stählen, wobei der Korpus eine Zusammensetzung aus 9,75-10,7 Gew.-% Co, 0,5-2,5 Gew.-%, vorzugsweise 1,0-2,0 Gew.-% einer Gesamtmenge der Metalle Ti, Nb und Ta, sowie im übrigen WC hat, mit einer Koerzitivkraft von 10-15, vorzugsweise 11-14 kA/m, wobei die mit W legierte Binderphase einem S-Wert von 0,81-0,95, vorzugsweise 0,82-0,94, entspricht, und dass die Beschichtung aufweist:

eine erste (am weitesten innen liegende) Schicht aus TiC$_x$N$_y$O$_z$, mit $0,7 \leq x+y+z \leq 1$, vorzugsweise z<0,5, noch bevorzugter y>x und z<0,2, mit gleichachsigen Körnern und einer Gesamtdicke <1 $\mu$m, vorzugsweise >0,1 $\mu$m, eine Schicht aus TiC$_x$N$_y$O$_z$ mit $0,7 \leq x+y+z \leq 1$, vorzugsweise mit z<0,2, x>0,3 und y>0,2, besonders bevorzugt x>0,4, mit einer Dicke von 1-5 $\mu$m, vorzugsweise 1,5-4,5 $\mu$m mit säulenförmigen Körnern, eine Schicht aus texturiertem Al$_2$O$_3$, die aus der $\alpha$-Phase besteht, mit einer Dicke von 1-5 $\mu$m, vorzugsweise 1,5-4,5 $\mu$m, wobei die Al$_2$O$_3$-Schicht stark in der ($10\bar{1}4$)-Richtung texturiert ist, mit einem Texturkoeffizienten TC($10\bar{1}4$), der größer als 1,2 ist, vorzugsweise zwischen 1,4 und 4, oder in der (0006)-Richtung mit einem Texturkoeffizienten TC(0006), der größer als 1,2 ist, vorzugsweise zwischen 1,4 und 4,3 liegt, oder in der ($10\bar{1}2$)-Richtung mit einem Texturkoeffizienten TC($10\bar{1}2$), der größer als 2,5, vorzugsweise größer als 3 und besonders bevorzugt größer als 3,5 ist, wobei der Texturkoeffizient (TC) gemäß der folgenden Formel bestimmt wird:

$$TC(hkil) = \frac{I(hkil)}{I_o(hkil)} \left[ \frac{1}{n} \sum_{1}^{n} \frac{I(hkil)}{I_o(hkil)} \right]^{-1}$$

wobei
I(hkil) = gemessene Intensität der (hkil)-Reflexion, I$_o$(hkil) = Standardintensität gemäß JCPDS-Karte Nr. 46-1212, n = Anzahl von in der Berechnung verwendeten Reflexionen, wobei die verwendeten (hkil)-Reflexionen sind: $(10\bar{1}2)$, $(10\bar{1}4)$, $(11\bar{2}0)$, $(0006)$, $(11\bar{2}3)$, $(11\bar{2}6)$.

2. Schneidwerkzeugeinsatz nach dem vorstehenden Anspruch, **gekennzeichnet durch** einen Co-Gehalt von 9,9-10,5 Gew.-%.

3. Schneidwerkzeugeinsatz nach einem der vorstehenden Ansprüche, **gekennzeichnet durch** ein Verhältnis zwischen den Gewichtskonzentrationen von Ta und Nb von 7,0-12,0, vorzugsweise 7,6-11,4.

4. Schneidwerkzeugeinsatz nach einem der Ansprüche 1 und 2, **gekennzeichnet durch** ein Gewichtsverhältnis zwischen den Gewichtskonzentrationen von Ta und Nb von 1,0-5,0, vorzugsweise 1,5-4,5.

5. Schneidwerkzeugeinsatz nach einem der vorstehenden Ansprüche, **gekennzeichnet durch** einen Ti-Gehalt auf dem Niveau einer technischen Verunreinigung.

6. Schneidwerkzeugeinsatz nach einem der vorstehenden Ansprüche, **gekennzeichnet durch** eine dünne TiN-Deckschicht auf der $\alpha$-$Al_2O_3$-Schicht.

7. Verfahren zum Herstellen eines Schneidwerkzeugeinsatzes, welcher einen Korpus aus Sintercarbid und eine Beschichtung aufweist, durch Herstellen eines Sintercarbidkörpers mit Hilfe der Pulvermetallurgietechnik, der eine Zusammensetzung von 9,75-10,7 Gew.-% Co, 0,5-2,5 Gew.-%, vorzugsweise 1,0-2,0 Gew.-% des Gesamtgehaltes der Metalle Ti, Nb und Ta und im übrigen WC enthält, mit einer Koerzitivkraft von 10-15, vorzgusweise 11-14kA/m, wobei die mit W legierte Binderphase einem S-Wert von 0,81-0,95, vorzugsweise 0,82-0,94, entspricht, und Beschichten des Sintercarbidkörpers mit

einer ersten (am weitesten innen liegenden) Schicht aus $TiC_xN_yO_z$ mit $0,7\leq x+y+z\leq 1$, vorzugsweise z<0,5, noch bevorzugter y>x und z<0,2, mit gleichachsigen Körnern und einer Gesamtdicke <1 $\mu$m, vorzugsweise >0,1 $\mu$m, unter Verwendung bekannter CVD-Techniken,
einer Schicht aus $TiC_xN_yO_z$ mit $0,7\leq x+y+z\leq 1$, vorzugsweise mit z<0,2, x>0,3 und y>0,2, besonders bevorzugt x>0,4, mit einer Dicke von 1-5 $\mu$m, vorzugsweise 1,5-4,5 $\mu$m mit säulenförmigen Körpern unter Verwendung der MTCVD-Technik mit Acetonitril als Kohlenstoff- und Stickstoffquelle zum Ausbilden der Schicht in dem Temperaturbereich von 700-950°C,
einer Schicht aus texturiertem $Al_2O_3$, die aus der $\alpha$-Phase besteht, mit einer Dicke von 1-5 $\mu$m, vorzugsweise 1,5-4,5 $\mu$m, unter Verwendung der bekannten CVD-Technik, und
mögliches Abscheiden einer dünnen obersten TiN-Schicht auf dem $\alpha$-$Al_2O_3$ unter Verwendung bekannter Techniken.

8. Verwendung eines Schneidwerkzeugeinsatzes nach einem der Ansprüche 1 bis 6 zum Fräsen von Stählen mit Schnittgeschwindigkeiten von 75-400 m/min, vorzugsweise 100-300 m/min, mit einem durchschnittlichen Zahnvorschub von 0,08-0,5 mm, vorzugsweise 0,1-0,4 mm, je nach Schneidgeschwindigkeit und Einsatzgeometrie.

**Revendications**

1. Plaquette de coupe, comprenant un corps en carbure cémenté et un revêtement, particulièrement utile pour le fraisage humide ou à sec des aciers, dans laquelle ledit corps présente une composition de 9,75 à 10,7% en poids de Co, de 0,5 à 2,5% en poids, de préférence de 1,0 à 2,0% en poids de la quantité totale des métaux Ti, Nb et Ta et le reste étant WC, avec une coercitivité de 10 à 15, de préférence de 11 à 14 kA/m, la phase liante alliée avec le W correspondant à une valeur S de 0,81 à 0,95, de préférence de 0,82 à 0,94, et ledit revêtement comprenant

- une première couche (la plus interne) de $TiC_xN_yO_z$ avec $0,7\leq x+y+z\leq 1$, de préférence z<0,5, plus préférentiellement y>x et z<0,2, avec des grains équiaxes et une épaisseur totale <1 $\mu$m, de préférence >0,1 $\mu$m ;
- une couche de $TiC_xN_yO_z$ avec $0,7\leq x+y+z\leq 1$, de préférence avec z<0,2, x>0,3 et y>0,2, de préférence x>0,4, avec une épaisseur de 1 à 5 $\mu$m, de préférence 1,5 à 4,5 $\mu$m avec des grains colonnaires;
- une couche de $Al_2O_3$ texture composé de la phase $\alpha$ avec une épaisseur de 1 à 5 $\mu$m, de préférence de 1,5 à 4,5 $\mu$m, dans laquelle la couche d'$Al_2O_3$ est fortement texturée dans la direction (1014), avec un coefficient de texture TC(1014) supérieur à 1,2, de préférence entre 1,4 et 4, ou dans la direction (0006), avec un coefficient de texture TC (0006) supérieur à 1,2, de préférence entre 1,4 et 4,3 ou dans la direction (1012), avec un coefficient de texture TC $(10\bar{1}2)$ supérieur à 2,5, de préférence supérieur à 3, de préférence supérieur à 3,5.

le coefficient de texture (TC) étant déterminé selon la formule suivante:

$$TC(hkil) = \frac{I(hkil)}{I_0(hkil)} \left[ \frac{1}{n} \sum_{n=1}^{n} \frac{I(hkil)}{I_0(hkil)} \right]^{-1}$$

dans laquelle
I(hkil) = intensité mesurée de la réflexion (hkil)
$I_0$(hkil) = intensité standard conforme à la carte JCPDS N° 46-1212 n = nombre de réflexions utilisées dans le calcul
les réflexions (hkil) utilisées sont: $(10\bar{1}2)$, $(10\bar{1}4)$, $(11\bar{2}0)$, $(0006)$, $(11\bar{2}3)$, $(11\bar{2}6)$.

2. Plaquette de coupe selon la revendication précédente, **caractérisée par** un contenu en Co de 9,9 à 10,5% en poids.

3. Plaquette de coupe selon l'une quelconque des revendications précédentes, **caractérisée par** un rapport entre les concentrations en poids de Ta et Nb de 7,0 à 12,0, de préférence 7,6 à 11,4.

4. Plaquette de coupe selon l'une quelconque des revendications 1 et 2, **caractérisée par** un rapport entre les concentrations en poids de Ta et Nb de 1,0 à 5,0, de préférence de 1,5 à 4,5.

5. Plaquette de coupe selon l'une quelconque des revendications précédentes, **caractérisée par** un contenu en Ti du niveau d'impureté technique.

6. Plaquette de coupe selon l'une quelconque des revendications précédentes, **caractérisée par** une couche mince supérieure en TiN sur la couche $\alpha$-$Al_2O_3$.

7. Un procédé de fabrication d'une plaquette de coupe comprenant un corps en carbure cémenté et un revêtement, par

- la préparation par la technique de métallurgie des poudres, d'un corps en carbure cémenté ayant une composition de 9,75 à 10,7% en poids de Co, de 0,5 à 2,5% en poids, de préférence de 1,0 à 2,0% en poids total des métaux Ti, Nb et Ta et le reste étant du WC, avec une coercitivité de 10 à 15, de préférence de 11 à 14 kA/m, la phase liante alliée avec W correspondant à une valeur de S de 0,81 à 0,95, de préférence 0,82 à 0,94, et
- le revêtement du corps en carbure cémenté avec
- une première couche (la plus interne) de $TiC_xN_yO_z$ avec $0,7 \leq x+y+z \leq 1$, de préférence avec z<0,5, plus préférentiellement y>x et z<0,2, avec des grains équiaxes et une épaisseur totale <1 $\mu$m, de préférence >0,1 $\mu$m en utilisant des techniques connues de CVD ;
- une couche de $TiC_xN_yO_z$ avec $0,7 \leq x+y+z \leq 1$, de préférence avec z<0,2, x>0,3 et y>0,2, de préférence x>0,4, avec une épaisseur de 1 à 5 $\mu$m, de préférence de 1,5 à 4,5 $\mu$m avec des grains colonnaires en utilisant une technique MTCVD avec de l'acétonitrile comme source de carbone et d'azote pour former la couche dans la plage de température de 700 à 950°C ,
- une couche de $Al_2O_3$ texture composé de la phase $\alpha$ avec une épaisseur de 1 à 5 $\mu$m, de préférence de 1,5 à 4,5 $\mu$m en utilisant une technique connue de CVD, et
- éventuellement le dépôt d'une couche supérieure mince de TiN sur la couche en $\alpha$- $Al_2O_3$ en utilisant une technique connue.

8. L'utilisation de plaquettes de coupe selon les revendications 1 à 6 pour le fraisage des aciers à des vitesses de coupe de 75 à 400 m/min, de préférence de 100 à 300 m/min, avec un avance moyen par dent de 0,08 à 0,5 mm, de préférence de 0,1 à 0,4 mm en fonction de la vitesse de coupe et de la géométrie de la plaquette.

Fig 1

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1493845 A
- WO 9720083 A
- WO 9720081 A
- EP 1103635 A
- WO 2007069973 A